# EUROPEAN PATENT SPECIFICATION

(11) **EP 1 096 673 B1**
(45) Date of publication and mention of the grant of the patent: **02.02.2005**
(21) Application number: 99121531.0
(22) Date of filing: 29.10.1999
(51) Int. Cl.: H03G 3/30

(54) **A method and device for preventing saturation in a power amplifier control loop**
Verfahren und Vorrichtung zum Verhindern von Sättigung in einer Leistungsverstärker-Regelschleife
Procédé et dispositif de prévention de saturation dans une boucle de contrôle d'un amplificateur de puissance

(43) Date of publication of application: 02.05.2001
(73) Proprietor: SIEMENS AKTIENGESELLSCHAFT, 80333 München (DE)
(72) Inventor: Jensen, Niels Jorgen, 9490 Pandrup (DK)

(56) References cited:
- US-A- 5 278 994

## Description

The present invention relates to a method and device for preventing saturation in a power amplifier control loop.

JP-A-02302110 discloses a filter circuit rectifying and smoothing the harmonic component except the fundamental wave in order to form a control voltage. The control voltage is used to decrease the gain of a pre-stage high frequency amplifier.

JP-A-06216680 discloses an amplifier that has a higher harmonic detection part for detecting higher harmonic in the output waves of the amplifier, and a higher harmonic reference value generation part provided with a reference value for comparing a higher harmonic amount detected at the higher harmonic detection part with an allowable value.

US-A-5 712 593 discloses means for detecting the amount of distortion present in an output signal. A feedback signal is provided to control the bias point of the active devices. As drive levels increase, the increased harmonic distortion power detected causes the power amplifier bias to increase thus reducing distortion.

EP-A-0 834 988 discloses an audio device having a detector for measuring distortion in the output signal.

In particular, the invention can be used in GSM (Global System for Mobile communications) transmitters having power amplifier regulation loops, in particular for single, dual or triple bands. Although in principle applicable to any power amplifier containing system, the present invention and its underlying problems will be discussed with particular reference to such GSM transmitters.

Feedback control loops for power amplifiers often have a problem with saturation, when the power amplifier reaches the 1 dB compression point.

The reason for this is the non-linear transfer-function of the power amplifier which gives the output power versus control vortage). In the saturated region of the power amplifier, the control gain decreases towards zero. In practice, this means an open loop situation.

This mechanism creates three particular problems: One can easily violate switching spectrum requirements when ramping down, in a pulsed system like GSM. In other words, operating a power amplifier control loop in the saturated area will cause increased switching spectrum transients, and hereby the product will violate specifications and cause more disturbances (interferences) in other electronic parts during the TDMA (time division multiple access) up and down ramping. The power amplifier has maximum efficiency in this region, therefore one would like to operate the power amplifier close to this point, for most efficient use of the battery. When operating a power amplifier in a closed loop system, one does not know the distance from this region, because the point is dependent on temperature, supply voltage, and lot to lot variation.

### SUMMARY OF THE INVENTION

The present invention provides method method and device for preventing saturation in a power amplifier control loop according to claim 1 and 3, respectively.

As known in prior art, the power amplifier and the regulation loop are prevented to operate in the saturated area by saturation detection.

Furthermore, using saturation detection the designer of the power amplifier and the regulation loop has the advantage that he gets a feedback information, when the loop is entering the saturated area. The power amplifier can then be operated very close to the saturated area where the amplifier efficiency peaks.

The saturated area is detected using the spectral power of the second or another even spectral harmonic at the output of the power amplifier.

According to the invention, a local minimum of the second or other even spectral harmonic is used to detect a point of saturation of said power amplifier and the output power of said power amplifier is controlled such that it is kept at or below said point of saturation.

Advantageous embodiments of the invention are described in the dependent claims.

According to a further preferred embodiment, in response to said detected spectral power a control signal is fed in an integrator in the power amplifier control loop, said integrator inputting a corresponding control voltage said power amplifier.

### BRIEF DESCRIPTION OF THE DRAWINGS

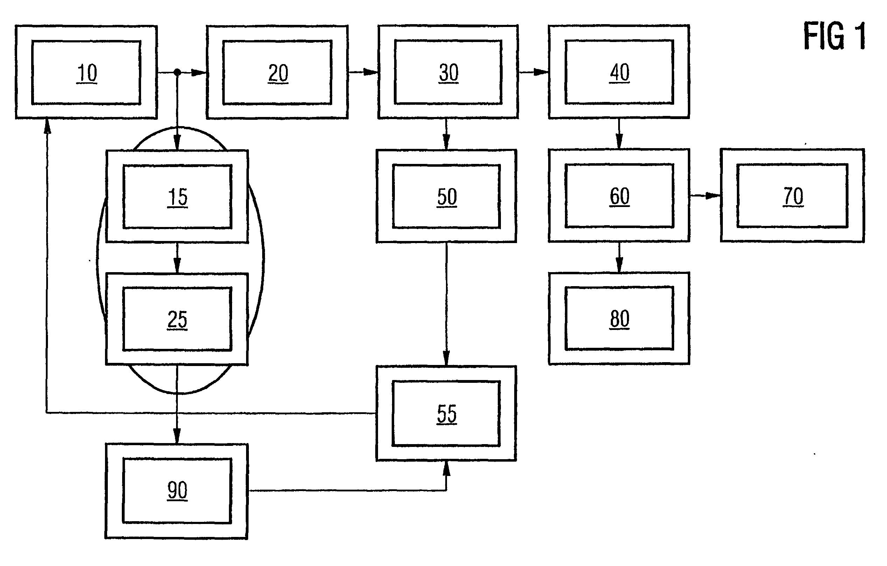

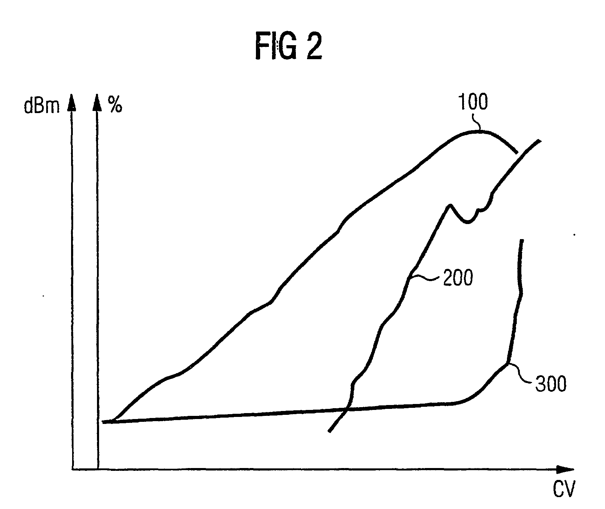

The present invention will become more fully understood by the following detailed description of preferred embodiments thereof in conjunction with the accompanying drawings in Figures 1 and 2, in which:
Figure 1 shows a power amplifier control loop according to an embodiment of the invention; and
Figure 2 shows a typical transfer function of a power amplifier having a control loop.

### DESCRIPTION OF THE PREFERRED EMBODIMENTS

Figure 1 shows a power amplifier control loop according to an embodiment of the invention and Figure 2 shows a typical transfer function of a power amplifier having a control loop.

In Figures 1 and 2, reference sign CV denotes a control voltage, 100 an efficiency curve, 200 a 2 harmonic curve, 300 a switching spectrum, 10 a power amplifier, 20 a matching means, 30 a coupler, 40 a low pass filter, 50 a power detector, 55 a power amplifier loop integrator, 90 a control unit, 60 a transmit/receive switch, 70 an antenna, 80 a receiver, 15 a 2 harmonic filter, and 25 a power detector.

As may be seen from Figure 2, even harmonic curves, for example a second harmonic curve 200, of the carrier frequency, have a local minimum just before the power amplifier enters the non-linear region, i.e. the switching spectrum 300 becomes infinite and the efficiency 100 becomes maximum.

The power amplifier arrangement shown in Figure 2 including the power amplifier 10, radio frequency matching means 20, coupler 30, low pass filter 40, power detector 50, power amplifier loop integrator 55, transmit/receive switch 60, antenna 70, receiver 80 and control unit 90 is well known and will not be further described here.

In particular, the loop between the coupler 30 and the power amplifier 10 including the power detector 50, the power amplifier loop integrator 55 and the control unit 90 is called the power amplifier control loop and is for stabilising the output power to a constant power, for example, 2 Watts in a GSM transmitter.

Therefore, the power detector 50 detects the output power at the coupler 30 and feds a corresponding signal in the integrator 55. The integrator 55 receives a control signal from the control unit 90 and inputs a corresponding control voltage CV to said power amplifier 10.

According to this embodiment of the invention, additionally a parallel notch filter 15 for the second harmonic on the output of the power amplifier 10 and a simple power detector 25 feeding an output signal to the control unit 90 are provided in order to make it possible to track the saturation of the power amplifier 10 by measuring the behaviour of the second harmonic and to control the output power such that the linear region is not left.

Having this arrangement on the output of the power amplifier 10, the control unit 90 can monitor the level of the second harmonic during a burst and search for the local minimum in the second harmonic curve 200.

When the control unit 90 detects this local minimum, precaution can be taken, for example, to reduce the output power or determine that the output power is not allowed to increase much further, and problems due to a saturation of the regulation loop can be avoided.

Although the present invention has been described with respect to preferred embodiments thereof, it should be understood that many modifications can be performed without departing from the scope of the invention as defined by the appended claims.

In particular, the invention is applicable to any power amplifier control loop containing system.

## Claims

1. A method for preventing saturation in a power amplifier (10) control loop, comprising the steps of:
- detecting the spectral power of the second or other even spectral harmonic of the carrier frequency at the output of the power amplifier (10);
- controlling the output power of the power amplifier (10) in accordance with said detected spectral power of said spectral harmonic so that the output power is kept at or below a point of saturation;
**characterized in that**:
the step of controlling the output power is performed using a local minimum of the spectral power of the second or other even spectral harmonic in order to detect said point of saturation of said power amplifier (10).

2. The method according to claim 1, wherein in response to said detected spectral power a control signal is fed in an integrator (55) in the power amplifier control loop, said integrator (55) inputting a corresponding control voltage (CV) to said power amplifier (10).

3. A device (90) for preventing saturation in a power amplifier (10) control loop, comprising:
- a notch filter (15) connected to the output of the power amplifier (10) for extracting a spectral harmonic of the carrier frequency;
- a power detector (25) for detecting the spectral power of said spectral harmonic passing through said notch filter (15); and
- a control unit (90) for receiving said detected spectral power and for controlling the output power of the power amplifier (10) in accordance with said detected spectral power of said spectral harmonic,
**characterized in that**:
the control unit (90) is adapted to:
- search a local minimum of the spectral power of the second or other even harmonic in order to detect a point of saturation of said power amplifier (10); and
- control the output power of said power amplifier (10) so that it is kept at or below said point of saturation.

4. A device (90) according to claim 3, wherein: said notch filter (15) is adapted to extract the second or other even spectral harmonic at the output of the power amplifier (10).

5. A device (90) according to claim 3, wherein: the control unit (90) is adapted to feed, in response to said detected spectral power, a control signal to an integrator (55) in the power amplifier control loop, said integrator (55) adapted to input a corresponding control voltage (CV) to said power amplifier (10).

## Patentansprüche

1. Verfahren zum Verhindern von Sättigung in der Regelschleife eines Leistungsverstärkers (10), das folgende Schritte umfasst:
- Erfassung der Bandbreitenleistung der zweiten oder einer anderen geradzahligen Bandbreitenoberwelle der Trägerfrequenz am Ausgang des Leistungsverstärkers (10);
- Regelung der Ausgangsleistung des Leistungsverstärkers (10) entsprechend besagter erfasster Bandbreitenleistung der besagten Bandbreiten-Oberwelle, so dass die Ausgangsleistung am oder unterhalb eines Sättigungspunktes gehalten wird;
**dadurch gekennzeichnet, dass**:
der Schritt der Regelung der Ausgangsleistung mit Hilfe eines örtlichen Minimums der Bandbreitenleistung der zweiten oder einer anderen geradzahligen Bandbreitenoberwelle bewerkstelligt wird, um besagten Sättigungspunkt des besagten Leistungsverstärkers (10) zu erfassen.

2. Verfahren nach Anspruch 1, bei dem in Reaktion auf besagte erfasste Bandbreitenleistung ein Regelsignal in einen Integrator (55) in der Leistungsverstärker-Regelschleife gespeist wird, wobei besagter Integrator (55) eine entsprechende Steuerspannung (CV) in besagten Leistungsverstärker (10) speist.

3. Gerät (90) zur Verhinderung von Sättigung in der Regelschleife eines Leistungsverstärkers (10), das Folgendes umfasst:
- einen Sperrfilter (15), der an den Ausgang des Leistungsverstärkers (10) angeschlossen ist, um eine Bandbreiten-Oberwelle der Trägerfrequenz zu extrahieren;
- einen Leistungsdetektor (25) zur Erfassung der Bandbreitenleistung besagter Bandbreiten-Oberwelle, die durch besagten Sperrfilter (15) geht;
- ein Steuergerät (90) zum Empfangen besagter erfasster Bandbreitenleistung und zur Regelung der Ausgangsleistung des Leistungsverstärkers (10) entsprechend besagter erfasster Bandbreitenleistung der besagten Bandbreiten-Oberwelle,
**dadurch gekennzeichnet, dass**:
das Steuergerät (90) so angepasst ist, dass es:
- nach einem örtlichen Minimum der Bandbreitenleistung besagter zweiter oder anderer geradzahligen Oberwelle sucht, um einen Sättigungspunkt des besagten Leistungsverstärkers (10) zu erfassen; und
- die Ausgangsleistung besagten Leistungsverstärkers (10) so regelt, dass sie am oder unterhalb des besagten Sättigungspunktes gehalten wird.

4. Gerät (90) nach Anspruch 3, **bei dem:** besagter Sperrfilter (15) so angepasst ist, dass er die zweite oder andere geradzahlige Bandbreiten-Oberwelle am Ausgang des Leistungsverstärkers (10) extrahiert.

5. Gerät (90) nach Anspruch 3, **bei dem:** das Steuergerät (90) so angepasst ist, dass es in Reaktion auf besagte erfasste Bandbreitenleistung ein Regelsignal an einen Integrator (55) in der Leistungsverstärker-Regelschleife speist, wobei besagter Integrator (55) so angepasst ist, dass er eine entsprechende Steuerspannung (CV) in besagten Leistungsverstärker (10) einspeist.

## Revendications

1. Procédé de prévention de la saturation dans une boucle d'asservissement d'un amplificateur de puissance (10), comprenant les étapes consistant à :
- détecter la puissance spectrale de la deuxième harmonique spectrale ou d'une autre harmonique paire de la fréquence porteuse à la sortie de l'amplificateur de puissance (10) ;
- réguler la puissance de sortie de l'amplificateur de puissance (10) conformément à ladite puissance spectrale détectée de ladite harmonique spectrale de sorte que la puissance de sortie est maintenue à un point de saturation ou au-dessous de celui-ci ;
**caractérisé en ce que :**
l'étape de régulation de la puissance de sortie est exécutée au moyen d'un minimum local de la puissance spectrale de la deuxième harmonique spectrale ou d'une autre harmonique paire afin de détecter ledit point de saturation dudit amplificateur de puissance (10).

2. Procédé selon la revendication 1, dans lequel, en réponse à ladite puissance spectrale détectée, un signal de commande est envoyé dans un intégrateur (55) dans la boucle d'asservissement d'amplificateur de puissance, ledit intégrateur (55) délivrant en entrée une tension de commande correspondante (CV) audit amplificateur de puissance (10).

3. Dispositif (90) de prévention de la saturation dans une boucle d'asservissement d'un amplificateur de puissance (10), comprenant :
- un filtre coupe-bande (15) relié à la sortie de l'amplificateur de puissance (10) pour extraire une harmonique spectrale de la fréquence porteuse;
- un détecteur de puissance (25) pour détecter la puissance spectrale de ladite harmonique spectrale traversant ledit filtre coupe-bande (15); et
- une unité de commande (90) pour recevoir ladite puissance spectrale détectée et pour réguler la puissance de sortie de l'amplificateur de puissance (10) conformément à ladite puissance spectrale détectée de ladite harmonique spectrale;
**caractérisé en ce que** :
l'unité de commande (90) est adaptée pour :
- rechercher un minimum local de la puissance spectrale de la deuxième harmonique ou d'une autre harmonique paire afin de détecter un point de saturation dudit amplificateur de puissance (10) ; et
- réguler la puissance de sortie dudit amplificateur de puissance (10) de sorte qu'elle est maintenue audit point de saturation ou au-dessous de celui-ci.

4. Dispositif (90) selon la revendication 3, dans lequel : ledit filtre coupe-bande (15) est adapté pour extraire la deuxième harmonique spectrale ou une autre harmonique paire à la sortie de l'amplificateur de puissance (10).

5. Dispositif (90) selon la revendication 3, dans lequel : l'unité de commande (90) est adaptée pour délivrer un signal de commande, en réponse à ladite puissance spectrale détectée, à un intégrateur (55) dans la boucle d'asservissement d'amplificateur de puissance, ledit intégrateur (55) étant adapté pour délivrer en entrée une tension de commande correspondante (CV) audit amplificateur de puissance (10).
